# EUROPÄISCHE PATENTSCHRIFT

(11) **EP 2 641 455 B1**
(45) Veröffentlichungstag und Bekanntmachung des Hinweises auf die Patenterteilung: **25.06.2014**
(21) Anmeldenummer: 11793690.6
(22) Anmeldetag: 15.11.2011
(51) Int. Cl.: H05H 1/46, H01J 37/32

(54) **MIKROWELLEN-ICP-RESONATOR**
MICROWAVE ICP RESONATOR
RÉSONATEUR MICRO-ONDES DE PRODUCTION DE PLASMA PAR INDUCTION (ICP)

(30) Priorität: 15.11.2010 DE 102010043940
(43) Veröffentlichungstag der Anmeldung: 25.09.2013
(73) Patentinhaber: Forschungsverbund Berlin E.V., 12489 Berlin (DE)
(72) Erfinder: GESCHE, Roland, 63500 Seligenstadt (DE); PORTEANU, Horia-Eugen, 13055 Berlin (DE); KÜHN, Silvio, 16348 Wandlitz (DE)
(74) Vertreter: Gulde & Partner
(86) Internationale Anmeldenummer: PCT/EP2011/070128
(87) Internationale Veröffentlichungsnummer: WO 2012/065980

(56) Entgegenhaltungen:
- EP-A1- 0 874 537
- WO-A1-01/20640
- DE-A1-102007 056 138
- FR-A1- 2 766 321
- US-A- 3 760 304

## Beschreibung

### Technisches Gebiet

Die Erfindung betrifft einen Mikrowellenresonator zur induktiven Erzeugung eines Plasmas und einen Plasmagenerator mit einem solchen Mikrowellenresonator.

### Stand der Technik

Im Stand der Technik sind zahlreiche Verfahren bekannt, um ein Plasma aus einem Prozessgas zu erzeugen. Ebenso sind zahlreiche Einsatzmöglichkeiten eines Plasmas bekannt. So kann ein Plasmagenerator wie der der Erfindung beispielsweise bei der Behandlung von Oberflächen beim Beschichten mittels Plasma Enhanced Chemical Vapour Deposition (PECVD), Atomic Layer Deposition (ALD) oder Sputtern, beim Plasmaätzen, zur Reinigung von Prozesskammern oder zum Aktivieren von Oberflächen verwendet werden. Auch Anwendungen im medizinischen Bereich wie zum Beispiel bei der Behandlung von Haut oder zur Entkeimung sind möglich. Weiterhin können Plasmageneratoren in der Analysentechnik verwendet werden.

Zur Plasmaerzeugung ist es bekannt, ein Prozessgas durch eine zumindest stückweise dielektrisch ausgebildete Röhre zu leiten, das dort kapazitiv angeregt wird. Die leitfähige Elektrode oder die leitfähigen Elektroden befinden sich dabei außerhalb der Röhre und stehen somit nicht in direktem Kontakt mit dem Plasma. Der Innendurchmesser einer solchen Röhre beträgt üblicherweise zwischen 1 mm und wenigen Zentimetern. Bei der kapazitiven Kopplung stellt die Kapazität der dielektrischen Wand der Röhre wegen des dort auftretenden Spannungsabfalls einen erheblichen Nachteil dar.

DE 10 2007 056 138 A1 offenbart eine Mikrowellen-Plasmaquelle umfassend einen Wellenleiter, einem Mikrowellenoszillator verbunden mit dem Wellen-leiter, einem Hohlraum und eine Gaszufuhr.

### Zusammenfassung der Erfindung

Die Erfindung führt daher einen Mikrowellenresonator zur induktiven Erzeugung eines Plasmas ein, welcher aufgrund der induktiven Anregung des Prozessgases den obengenannten Nachteil vermeidet. Der Mikrowellenresonator umfasst eine erste Röhre, welche für das Anschließen an eine Zuführeinrichtung für ein Prozessgas und zum Leiten des Prozessgases ausgebildet ist und ein dielektrisches Material umfasst. Erfindungsgemäß ist eine leitfähige, vorzugsweise metallische, Platte vorgesehen, welche ein erstes, vorzugsweise zylindrisches, Loch und einen ersten Schlitz aufweist. Das erste Loch erstreckt sich von einer ersten Öffnung auf einer ersten Seite der leitfähigen Platte zu einer zweiten Öffnung auf einer der ersten Seite gegenüber liegenden zweiten Seite der leitfähigen Platte. Die erste Röhre (beziehungsweise ein Abschnitt der ersten Röhre mit dem dielektrischen Material) ist in dem ersten Loch angeordnet. Der erste Schlitz ist dabei zu der ersten und der zweiten Seite der leitfähigen Platte und zu dem ersten Loch geöffnet.

Die erfindungsgemäße Struktur ergibt einen Resonator, bei dem die Innenwand des ersten Loches die Antenne zur induktiven Einkopplung von Mikrowellenenergie in das Prozessgas zur Plasmaerzeugung bildet. Das bedeutet, dass die Stromdichte auf der Innenwand des ersten Lochs das Magnetfeld erzeugt, welches die Plasmaanregung hervorruft. Das erste Loch stellt somit wenigstens teilweise die Induktivität des Mikrowellenresonators dar. Der erste Schlitz bildet dabei die zugehörige Kapazität. Der erste Schlitz kann, wie alle weiteren Schlitze bei den weiteren Ausführungsbeispielen der Erfindung, ganz oder teilweise mit einem dielektrischen Material gefüllt werden.

Eine Resonanzfrequenz des Mikrowellenresonators liegt vorzugsweise zwischen 2 und 3 GHz, besonders bevorzugt beträgt sie 2,45 GHz.

Die Erfindung schafft eine Anregungsstruktur, die eine effiziente induktive Plasmaanregung (ICP) bei Mikrowellenfrequenzen ermöglicht. Hierdurch werden die Vorteile der ICP-Technologie mit denen der Mikrowellenplasmen kombiniert. Durch die induktive Kopplung der Magnetfelder kann die Mikrowellenenergie günstig durch die Wand der dielektrischen Röhre in das Prozessgas eingekoppelt werden, wodurch die Verluste, die aufgrund des Dielektrikums bei der kapazitiven Einkopplung auftreten, vermieden werden.

Als "Platte" wird im Rahmen der Erfindung ein Körper angesehen, der entlang zweier Raumachsen eine deutlich größere, vorzugsweise wenigstens fünfmal, besser jedoch wenigstens zehnmal größere Ausdehnung aufweist als in der verbleibenden Raumachse.

Der erste Schlitz kann zusätzlich zu einer ersten Randfläche der leitfähigen Platte geöffnet sein. Bei dieser Ausführungsform können auch eine Mehrzahl von Paaren von ersten Löchern und ersten Schlitzen vorgesehen sein, um die Menge des in einer gegebenen Zeitspanne erzeugbaren Plasmas zu erhöhen. Dieses Prinzip lässt sich natürlich auch auf alle anderen Ausführungsbeispiele übertragen.

Der Mikrowellenresonator kann auch ein zweites, ebenfalls vorzugsweise zylindrisches, Loch aufweisen, das sich von einer dritten Öffnung auf der ersten Seite der leitfähigen Platte zu einer vierten Öffnung auf der zweiten Seite der leitfähigen Platte erstreckt. Bei dieser alternativen Ausführungsform ist der erste Schlitz zu dem zweiten Loch geöffnet. Dadurch wird der erste Schlitz an seinen beiden Enden durch ein Loch abgeschlossen. Natürlich können auch mehrere solcher durch einen Schlitz verbundenen Paare von Löchern vorgesehen sein, um das Plasmavolumen zu erhöhen. Diese Ausführungsform bietet den Vorteil, dass die leitfähige Platte an ihrer gesamten Umfangsfläche auf Masse gelegt werden kann.

Bevorzugt besitzt diese Ausführungsform des erfindungsgemäßen Mikrowellenresonators eine zweite Röhre, die ebenfalls für das Anschließen an die Zuführeinrichtung für das Prozessgas und zum Leiten des Prozessgases ausgebildet ist. Die zweite Röhre ist in dem zweiten Loch angeordnet und umfasst ebenfalls ein dielektrisches Material.

Der Mikrowellenresonator kann auch noch eine dritte Röhre, eine vierte Röhre, ein drittes, vorzugsweise zylindrisches, Loch und ein viertes, ebenfalls vorzugsweise zylindrisches, Loch aufweisen. Dabei sind die dritte und die vierte Röhre für das Anschließen an die Zuführeinrichtung für das Prozessgas und zum Leiten des Prozessgases ausgebildet und umfassen ein dielektrisches Material. Das dritte und das vierte Loch erstrecken sich von einer fünften Öffnung auf der ersten Seite der leitfähigen Platte zu einer sechsten Öffnung auf der zweiten Seite der leitfähigen Platte beziehungsweise von einer siebten Öffnung auf der ersten Seite der leitfähigen Platte zu einer achten Öffnung auf der zweiten Seite der leitfähigen Platte. Die dritte Röhre und die vierte Röhre sind in dem dritten Loch beziehungsweise dem vierten Loch angeordnet.

Bevorzugt weist der Mikrowellenresonator dabei einen zweiten Schlitz auf, der zu der ersten und der zweiten Seite der leitfähigen Platte, sowie zu dem dritten und dem vierten Loch geöffnet ist. Auch der zweite Schlitz kann ganz oder teilweise mit einem Dielektrikum gefüllt sein.

In einer vorteilhaften Ausführungsform kreuzen sich der erste und der zweite Schlitz, vorzugsweise in einem wenigstens näherungsweise rechten Winkel.

Der Mikrowellenresonator kann dabei eine rechteckige, vorzugsweise quadratische, oder elliptische, vorzugsweise kreisförmige, Öffnung aufzuweisen, die zu der ersten und der zweiten Seite der leitfähigen Platte geöffnet und in einem Kreuzungsbereich des ersten und des zweiten Schlitzes angeordnet ist.

Der Mikrowellenresonator kann eine an einer zweiten Randfläche der leitfähigen Platte angeordnete Massekontaktierung besitzen. In Ausführungsformen, bei denen sich keiner der Schlitze zu einer Randfläche des Mikrowellenresonators öffnet, kann die gesamte Randfläche eine Massekontaktierung besitzen.

Ein zweiter Erfindungsaspekt führt einen Plasmagenerator mit einem Mikrowellenresonator gemäß dem ersten Erfindungsaspekt ein. Der Plasmagenerator besitzt wenigstens eine mit dem Mikrowellenresonator verbundene Zuführeinrichtung für ein Prozessgas und eine Anregungsvorrichtung zum Anregen des Mikrowellenresonators.

Der Plasmagenerator der Erfindung kann für alle bekannten Plasmaverfahren, sowohl im Niederdruckbereich, als auch bei Atmosphärendruck eingesetzt werden. Durch die elektrodenlose Plasmaanregung ist der Betrieb sowohl mit Inertgasen, als auch mit Reaktivgasen und deren Gemischen möglich.

Besonders bevorzugt umfasst die Anregungsvorrichtung ein aktives Schaltelement, so dass die Anregungsvorrichtung und der Mikrowellenresonator einen Oszillator darstellen. Der Verstärker "entdämpft" den Mikrowellenresonator, wodurch sich ein "freilaufender" Oszillator bildet.

Alternativ kann der Plasmagenerator aber auch über eine als Mikrowellengenerator ausgeführte Anregungsvorrichtung verfügen, die ausgebildet ist, ein Mikrowellensignal zu erzeugen und an den Mikrowellenresonator auszugeben. In diesem Fall fungiert der Mikrowellenresonator als Teil der Impedanzanpassung. Der Mikrowellengenerator kann beispielsweise ein Magnetron oder ein Signalgenerator mit einem Leistungsverstärker sein.

Der Plasmagenerator kann über einen leitfähigen Hohlraum verfügen, in dem der Mikrowellenresonator angeordnet ist. Der Mikrowellengenerator ist dabei mit dem leitfähigen Hohlraum verbunden und ausgebildet, Mikrowellenenergie in den leitfähigen Hohlraum einzuspeisen.

Eine Ankopplung des Mikrowellenresonators kann jedoch alternativ auch auf verschiedenste Weisen verwirklicht werden, beispielsweise magnetisch durch eine um das erste Loch, beispielsweise oberhalb der leitfähigen Platte, herumgeführte Leiterschleife. Alternativ kann eine kapazitive Kopplung auf gegenüber liegenden Seiten des ersten Schlitzes angeordnet werden. Eine galvanische Einkopplung kann über Kontaktpunkte auf der ersten Seite der leitfähigen Platte des Mikrowellenresonators oder über Wellenleiterstrukturen verwirklicht sein.

### Kurzbeschreibung der Abbildungen

Die Erfindung wird im Folgenden anhand von Abbildungen von Ausführungsbeispielen näher beschrieben. Es zeigen:
Abb. 1 ein erstes Ausführungsbeispiel der Erfindung;
Abb. 2 ein zweites Ausführungsbeispiel der Erfindung; und
Abb. 3 ein drittes Ausführungsbeispiel der Erfindung.

### Ausführungsbeispiele der Erfindung

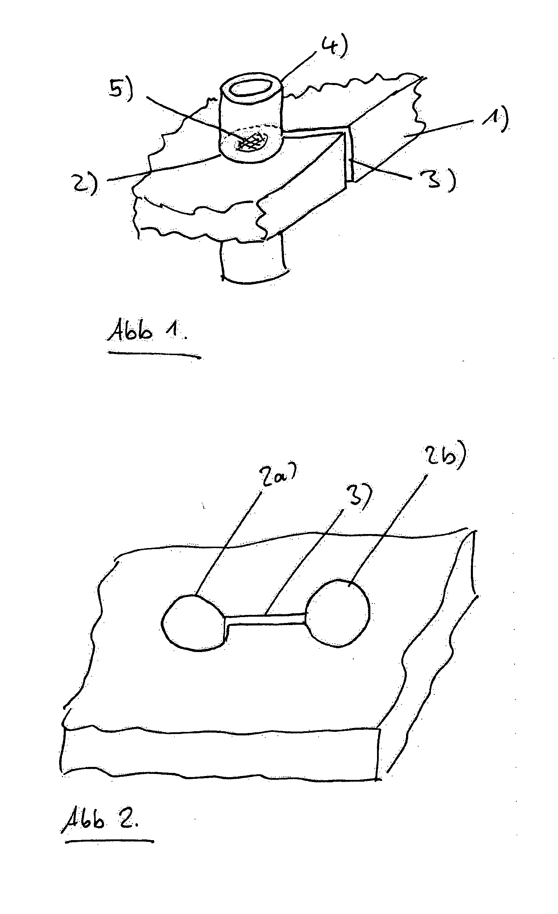

Abb. 1 zeigt ein erstes Ausführungsbeispiel der Erfindung. Eine leitfähige, vorzugsweise metallische Platte 1 umfasst ein Loch 2, welches als induktive Koppelschleife zu einem Plasma 5 dient und in dem eine Röhre 4 aus einem dielektrischen Material angeordnet ist, durch das das Prozessgas geleitet wird. Die leitfähige Platte kann prinzipiell beliebig groß sein, also auch an einer mehr oder weniger beliebigen Stelle an einer Masse befestigt sein, was z. B. die Kühlung vereinfacht. Ein Schlitz 3 in der leitfähigen Platte bildet eine Kapazität, welche zusammen mit der Induktivität des Lochs einen Resonanzkreis ausbildet. Das Prozessgas wird im Bereich des Lochs 2 angeregt, wodurch dort das Plasma 5 entsteht. In dem Ausführungsbeispiel der Abb. 1 öffnet sich der Schlitz 3 zu einer (schmalen) Stirnfläche der leitfähigen Platte 1. Er kann beispielsweise ganz oder teilweise mit einem Dielektrikum gefüllt sein, wodurch sich vorteilhafterweise eine räumliche Trennung eines Raumes einer Prozesskammer auf einer Seite der leitfähigen Platte 1 und der Umgebung ergibt.

Abb. 2 zeigt ein zweites Ausführungsbeispiel der Erfindung. Bei diesem Ausführungsbeispiel sind zwei Löcher 2a und 2b vorgesehen, die durch den Schlitz 3 verbunden sind. Der Schlitz 3 kann wiederum ganz oder teilweise durch ein Dielektrikum gefüllt sein. Es können bei dieser Ausführungsform der Erfindung ein oder zwei Röhren für das Prozessgas vorgesehen werden. Der Vorteil dieses Ausführungsbeispiels besteht darin, dass die Grundplatte außen rundherum auf Masse liegen kann, weil der Schlitz 3 nicht zu einer Schmalseite der leitfähigen Platte 1 geöffnet ist, was die konstruktive Umsetzung vereinfacht.

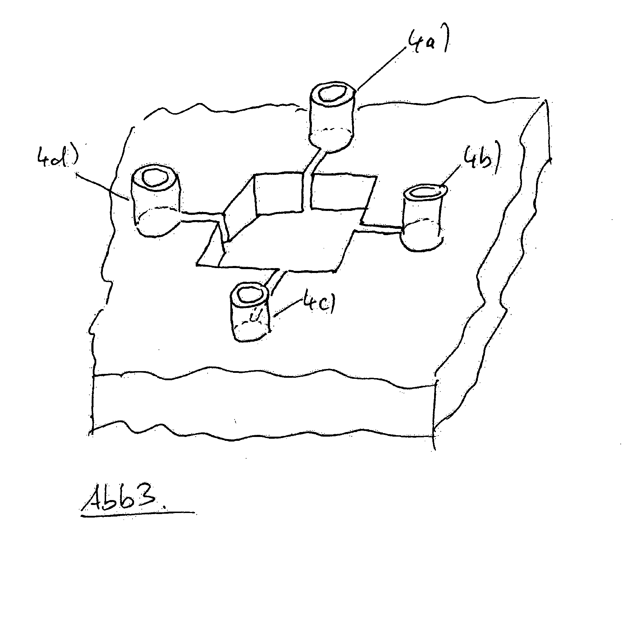

Abb. 3 zeigt ein drittes Ausführungsbeispiel der Erfindung. Das dritte Ausführungsbeispiel illustriert eine Anordnung mit vier Plasmabereichen, welche jeweils ein Loch und eine in dem Loch angeordnete Röhre 4a bis 4d aufweisen. Jedes der Löcher ist durch einen Schlitz mit einer quadratischen Öffnung im Kreuzungsbereich der Schlitze verbunden. Dieses Konzept kann mit jeder beliebigen Anzahl von Plasmabereichen ausgeführt werden (beispielsweise als sternförmige Anordnungen mit Plasmabereichen an den Spitzen der als Schlitze ausgeführten Strahlen des Sternes und einer optionalen zentralen Öffnung in Form eines Vielecks mit einer zu der Zahl von Strahlen korrespondierenden Anzahl von Seiten oder in Form eines Kreises), weiterhin können diese Strukturen oder die Struktur aus Abb. 2 beliebig aneinander gereiht oder mit den Strukturen der anderen Ausführungsbeispiele kombiniert werden.

Grundsätzlich kann die Anregung des Mikrowellenresonators der Erfindung gemäß zweier Prinzipien realisiert werden:
1.) Der Mikrowellenresonator fungiert als Resonator, der durch eine angeschlossene Beschaltung entdämpft wird und damit einen "freilaufenden" Oszillator bildet.
2.) Es wird ein externer Mikrowellengenerator verwendet, z. B. ein Magnetron oder ein Signalgenerator mit einem Leistungsverstärker. Hierbei kann der Mikrowellenresonator als Teil der Impedanzanpassung verwendet werden.

Die Ankopplung des Mikrowellenresonators kann beispielsweise magnetisch, kapazitiv oder galvanisch oder über Wellenleiterstrukturen erfolgen. Eine magnetische Kopplung kann z. B. durch eine Leiterschleife gebildet werden, die oberhalb der leitfähigen Platte 1 um das Loch 2 herum geführt wird. Es kann jedoch auch eine galvanische Kopplung durch Kontaktpunkte auf der Oberfläche der leitfähigen Platte 1 in der Nähe des Lochs 2 oder des Schlitzes 3 vorgesehen werden. Eine kapazitive Kopplung lässt sich beispielsweise auf der Stirnfläche der Platte 1 beiderseits des Schlitzes 3 anordnen. Es könnte jedoch auch eine Quelle mit einem oder mehreren Resonatoren in einem leitenden Hohlraum angeordnet werden, in den Mikrowellenenergie eingespeist wird, z. B. aus einem Magnetron in der Art und Weise eines Mikrowellenherdes.

## Patentansprüche

1. Ein Mikrowellenresonator zur induktiven Erzeugung eines Plasmas (5), der Mikrowellenresonator umfassend eine erste Röhre (4), welche für das Anschließen an eine Zuführeinrichtung für ein Prozessgas und zum Leiten des Prozessgases ausgebildet ist und ein dielektrisches Material umfasst, und eine leitfähige, metallische, Platte (1), welche ein erstes, zylindrisches, Loch (2), das sich von einer ersten Öffnung auf einer ersten Seite der leitfähigen Platte (1) zu einer zweiten Öffnung auf einer der ersten Seite gegenüberliegenden zweiten Seite der leitfähigen Platte (1) erstreckt und in dem die erste Röhre (4) angeordnet ist, **dadurch gekennzeichnet, dass** die metallische Platte (1) einen ersten Schlitz (3) aufweist, wobei der erste Schlitz (3) zu der ersten und der zweiten Seite der leitfähigen Platte (1) und zu dem ersten Loch (2) geöffnet ist.

2. Der Mikrowellenresonator von Anspruch 1, bei dem der erste Schlitz (3) außerdem zu einer ersten Randfläche der leitfähigen Platte (1) geöffnet ist.

3. Der Mikrowellenresonator von Anspruch 1, mit einem zweiten, vorzugsweise zylindrischen, Loch (2), das sich von einer dritten Öffnung auf der ersten Seite der leitfähigen Platte (1) zu einer vierten Öffnung auf der zweiten Seite der leitfähigen Platte (1) erstreckt, wobei der erste Schlitz (3) zu dem zweiten Loch (2) geöffnet ist.

4. Der Mikrowellenresonator von Anspruch 3, mit einer zweiten Röhre (4), die für das Anschließen an die Zuführeinrichtung für das Prozessgas und zum Leiten des Prozessgases ausgebildet und in dem zweiten Loch (2) angeordnet ist und die ein dielektrisches Material umfasst.

5. Der Mikrowellenresonator von Anspruch 4, mit einer dritten Röhre (4), einer vierten Röhre (4), einem dritten, vorzugsweise zylindrischen, Loch (2) und einem vierten, vorzugsweise zylindrischen, Loch (2), wobei die dritte und die vierte Röhre (4) für das Anschließen an die Zuführeinrichtung für das Prozessgas und zum Leiten des Prozessgases ausgebildet sind und ein dielektrisches Material umfassen, wobei sich das dritte und das vierte Loch (2) von einer fünften Öffnung auf der ersten Seite der leitfähigen Platte (1) zu einer sechsten Öffnung auf der zweiten Seite der leitfähigen Platte (1) beziehungsweise von einer siebten Öffnung auf der ersten Seite der leitfähigen Platte (1) zu einer achten Öffnung auf der zweiten Seite der leitfähigen Platte (1) erstrecken, und wobei die dritte Röhre (4) und die vierte Röhre (4) in dem dritten Loch (2) beziehungsweise dem vierten Loch (2) angeordnet sind.

6. Der Mikrowellenresonator von Anspruch 5, mit einem zweiten Schlitz (3), der zu der ersten und der zweiten Seite der leitfähigen Platte (1), sowie zu dem dritten und dem vierten Loch (2) geöffnet ist.

7. Der Mikrowellenresonator von Anspruch 6, bei dem sich der erste und der zweite Schlitz (3) kreuzen.

8. Der Mikrowellenresonator von Anspruch 7, bei dem sich der erste und der zweite Schlitz (3) in einem wenigstens näherungsweise rechten Winkel kreuzen.

9. Der Mikrowellenresonator von einem der Ansprüche 7 oder 8, mit einer rechteckigen, vorzugsweise quadratischen, oder elliptischen, vorzugsweise kreisförmigen, Öffnung, die zu der ersten und der zweiten Seite der leitfähigen Platte (1) geöffnet und in einem Kreuzungsbereich des ersten und des zweiten Schlitzes (3) angeordnet ist.

10. Der Mikrowellenresonator von einem der vorhergehenden Ansprüche, mit einer an einer zweiten Randfläche der leitfähigen Platte (1) angeordneten Massekontaktierung.

11. Ein Plasmagenerator mit einem Mikrowellenresonator nach einem der vorhergehenden Ansprüche, einer mit dem Mikrowellenresonator verbundenen Zuführeinrichtung für ein Prozessgas und einer Anregungsvorrichtung zum Anregen des Mikrowellenresonators.

12. Der Plasmagenerator von Anspruch 11, bei dem die Anregungsvorrichtung ein aktives Schaltelement umfasst, so dass die Anregungsvorrichtung und der Mikrowellenresonator einen Oszillator darstellen.

13. Der Plasmagenerator von Anspruch 11, bei dem die Anregungsvorrichtung einen Mikrowellengenerator umfasst, der ausgebildet ist, ein Mikrowellensignal zu erzeugen und an den Mikrowellenresonator auszugeben.

14. Der Plasmagenerator von Anspruch 13, mit einem leitfähigen Hohlraum, in dem der Mikrowellenresonator angeordnet ist, wobei der Mikrowellengenerator mit dem leitfähigen Hohlraum verbunden und ausgebildet ist, Mikrowellenenergie in den leitfähigen Hohlraum einzuspeisen.

15. Der Plasmagenerator von einem der Ansprüche 11 bis 13, bei dem eine Ankopplung des Mikrowellenresonators magnetisch durch eine um das erste Loch (2) herumgeführte Leiterschleife, durch eine auf gegenüberliegenden Seiten des ersten Schlitzes (3) angeordnete kapazitive Kopplung, galvanisch über Kontaktpunkte auf der ersten Seite der leitfähigen Platte (1) des Mikrowellenresonators oder über Wellenleiterstrukturen verwirklicht ist.

## Claims

1. A microwave resonator for inductively generating a plasma (5), the microwave resonator comprising a first tube (4) which is formed for being connected to a feed device for a process gas and for directing the process gas and which comprises a dielectric material; and a conductive metallic plate (1) which comprises a first cylindrical hole (2) which extends from a first opening on a first side of the conductive plate (1) to a second opening on a second side opposite the first side of the conductive plate (1) and in which the first tube (4) is arranged, **characterized in that** the metallic plate (1) includes a first slot (3), wherein the first slot (3) is open to the first and the second sides of the conductive plate (1) and to the first hole (2).

2. The microwave resonator of claim 1, in which the first slot (3) is also open to a first edge surface of the conductive plate (1).

3. The microwave resonator of claim 1, having a second, preferably cylindrical, hole (2) which extends from a third opening on the first side of the conductive plate (1) to a fourth opening on the second side of the conductive plate (1), wherein the first slot (3) is open to the second hole (2).

4. The microwave resonator of claim 3, having a second tube (4) which is formed for being connected to the feed device for the process gas and for directing the process gas and which is arranged in the second hole (2) and comprises a dielectric material.

5. The microwave resonator of claim 4, having a third tube (4), a fourth tube (4), a third, preferably cylindrical, hole (2) and a fourth, preferably cylindrical, hole (2), wherein the third and the fourth tubes (4) are formed for being connected to the feed device for the process gas and for directing the process gas and comprise a dielectric material, wherein the third and the fourth holes (2) extend from a fifth opening on the first side of the conductive plate (1) to a sixth opening on the second side of the conductive plate (1) and from a seventh opening on the first side of the conductive plate (1) to an eighth opening on the second side of the conductive plate (1), respectively, and wherein the third tube (4) and the fourth tube (4) are arranged in the third hole (2) and the fourth hole (2), respectively.

6. The microwave resonator of claim 5, having a second slot (3) which is open to the first and the second sides of the conductive plate (1), as well as to the third and the fourth holes (2).

7. The microwave resonator of claim 6, in which the first and the second slots (3) cross.

8. The microwave resonator of claim 7, in which the first and the second slots (3) cross at least approximately at right angles.

9. The microwave resonator of any one of claims 7 or 8, having a rectangular, preferably square, or elliptical, preferably circular, opening which is open to the first and the second sides of the conductive plate (1) and arranged in a crossing area of the first and the second slots (3).

10. The microwave resonator of any one of the preceding claims, having a ground contact arranged on a second edge surface of the conductive plate (1).

11. A plasma generator having a microwave resonator according to any one of the preceding claims, a feed device for a process gas connected to the microwave resonator and an excitation device for exciting the microwave resonator.

12. The plasma generator of claim 11, in which the excitation device comprises an active switching clement, so that the excitation device and the microwave resonator constitute an oscillator.

13. The plasma generator of claim 11, in which the excitation device comprises a microwave generator which is formed to generate a microwave signal and to output it to the microwave resonator.

14. The plasma generator of claim 13, having a conductive cavity in which the microwave resonator is arranged, wherein the microwave generator is connected to the conductive cavity and formed to feed microwave energy into the conductive cavity.

15. The plasma generator of any one of claims 11 to 13, in which a coupling of the microwave resonator is realized magnetically by a conductor loop led around the first hole (2), by a capacitive coupling arranged on opposite sides of the first slot (3), galvanically by way of contact points on the first side of the conductive plate (1) of the microwave resonator or by way of waveguide structures.

## Revendications

1. Un résonateur micro-ondes de production de plasma (5) par induction, le résonateur micro-ondes comprenant un premier tuyau (4) qui est formé pour être raccordé à un dispositif d'alimentation d'un gaz de procédé et pour conduire le gaz de procédé et qui comprend un matériau diélectrique, et une plaque métallique conductrice (1) qui comprend un premier trou cylindrique (2) qui s'étend d'un premier orifice sur le premier côté de la plaque conductrice (1) vers un second orifice sur un second côté opposé au premier côté de la plaque conductrice (1) et dans lequel le premier tuyau (4) est disposé, **caractérisé en ce que** la plaque métallique (1) présente une première fente (3), la première fente (3) étant ouverte vers le premier et le second côtés de la plaque conductrice (1) et vers le premier trou (2).

2. Le résonateur micro-ondes de la revendication 1, dans lequel la première fente (3) est en plus ouverte vers une première surface périphérique de la plaque conductrice (1).

3. Le résonateur micro-ondes de la revendication 1, avec un second trou (2), préférablement cylindrique, qui s'étend d'un troisième orifice sur le premier côté de la plaque conductrice (1) vers un quatrième orifice sur le second côté de la plaque conductrice (1), dans lequel la première fente (3) est ouverte vers le second trou (2).

4. Le résonateur micro-ondes de la revendication 3, avec un second tuyau (4) qui est formé pour être raccordé au dispositif d'alimentation du gaz de procédé et pour conduire le gaz de procédé et qui est disposé dans le second trou (2) et comprend un matériau diélectrique.

5. Lé résonateur micro-ondes de la revendication 4, avec un troisième tuyau (4), un quatrième tuyau (4), un troisième trou (2), préférablement cylindrique, et un quatrième trou (2), préférablement cylindrique, dans lequel le troisième et le quatrième tuyaux (4) sont formés pour être raccordé au dispositif d'alimentation du gaz de procédé et pour conduire le gaz de procédé et comprennent un matériau diélectrique, dans lequel le troisième et le quatrième trous (2) s'étendent respectivement d'un cinquième orifice sur le premier côté de la plaque conductrice (1) vers un sixième orifice sur le second côté de la plaque conductrice (1) et d'un septième orifice sur le premier côté de la plaque conductrice (1) vers un huitième orifice sur le second côté de la plaque conductrice (1), et dans lequel le troisième tuyau (4) et le quatrième tuyau (4) sont disposés respectivement dans le troisième trou (2) et le quatrième trou (2).

6. Le résonateur micro-ondes de la revendication 5, avec une seconde fente (3) qui est ouverte vers le premier et le second côtés de la plaque conductrice (1) ainsi que vers le troisième et le quatrième trou (2).

7. Le résonateur micro-ondes de la revendication 6, dans lequel la première et la seconde fentes (3) se croisent.

8. Le résonateur micro-ondes de la revendication 7, dans lequel la première et la seconde fentes (3) se croisent à un angle au moins approximativement droit.

9. Le résonateur micro-ondes d'une quelconque des revendications 7 ou 8, avec un orifice rectangulaire, préférablement carré, ou elliptique, préférablement circulaire, qui est ouverte vers le premier et le second de la plaque conductrice (1) et disposé dans une zone de croisement de la première et la seconde fentes (3).

10. Le résonateur micro-ondes de l'une quelconque des revendications précédentes, avec un contact de mise à la masse disposé sur la seconde surface périphérique de la plaque conductrice (1).

11. Un générateur de plasma avec un résonateur micro-ondes selon l'une quelconque des revendications précédentes, un dispositif d'alimentation d'un gaz de procédé relié au résonateur micro-ondes et un dispositif d'excitation pour exciter le résonateur micro-ondes.

12. Le générateur de plasma de la revendication 11, dans lequel le dispositif d'excitation comprend un élément de commutation actif, de sorte que le dispositif d'excitation et le résonateur micro-ondes constituent un oscillateur.

13. Le générateur de plasma de la revendication 11, dans lequel le dispositif d'excitation comprend un générateur de micro-ondes qui est formé pour produire et émettre un signal micro-ondes vers le résonateur micro-ondes,

14. Le générateur de plasma de la revendication 13, avec une cavité conductrice dans laquelle le résonateur micro-ondes est disposé, le générateur de micro-ondes étant relié à la cavité conductrice et formé pour alimenter la cavité conductrice en énergie miro-ondes.

15. Le générateur de plasma de l'une quelconque des revendications 11 à 13, dans lequel un coulage du résonateur micro-ondes est réalisé magnétiquement par une boucle conductrice passée autour du premier trou (2), par un couplage capacitif disposé sur les côtés opposés de la première fente (3), galvaniquement par l'intermédiaire de points de contact sur le premier côté de la plaque conductrice (1) du résonateur micro-ondes ou par l'intermédiaire de structures de guide d'ondes.
